# EUROPEAN PATENT APPLICATION

(11) **EP 4 184 722 A1**
(43) Date of publication of application: **24.05.2023**
(21) Application number: 21208665.6
(22) Date of filing: 17.11.2021
(51) Int. Cl.: H01R 12/78, H01R 13/405, H01R 12/59, H01R 12/69, H01R 4/02, H01R 12/77, H01R 43/24, H05K 1/18, H01R 13/627

(54) **ELECTRICAL CONNECTOR FOR CONNECTING A FLEXIBLE PRINTED CIRCUIT TO A CABLE HARNESS**

(71) Applicant: TE Connectivity Germany GmbH, 64625 Bensheim (DE); TE Connectivity Italia S.r.l., 10093 Collegno (TO) (IT); Tyco Electronics (Shanghai) Co., Ltd., Shanghai 201208 (CN)
(72) Inventor: KLENNER, Thomas, 64625 Bensheim (DE); LUPO, Federico, 10093 Torino (IT); WANG, Yongjia, Shanghai, 201208 (CN)
(74) Representative: Grünecker Patent- und Rechtsanwälte PartG mbB

(57) **Abstract**

The present invention relates to a connector system comprising a male connector with a first electrically insulated connector housing, a printed electronic circuitry with a terminal, and a female connector with a second electrically insulated connector housing. The printed electronic circuitry is in-molded with a supporting unit and is attached to the first electrically insulated connector housing of the male connector. It may comprise a flexible printed circuit. The female connector is adapted to mate with the male connector and to be connected to a cable harness. The present invention also relates to a multi-layer interface comprising a connector system as described above. The multi-layer interface comprises at least one functional layer comprising the printed electronic circuit with a terminal, and at least one electrically insulating layer, which is different from the at least one functional layer and which comprises the electrically insulated connector housing of the male connector. The multi-layer interface may additionally comprise a decorative layer comprising film or natural materials, decorative links, and/or conductive and/or dielectric inks.

## Description

The present invention relates to an electrical connector and in particular, the present invention relates to an electrical connector for connecting to a flexible printed circuit (FPC) board and a multi-layer interface comprising such an electrical connector for connecting to a cable harness.

FPC board connectors are used in electronic devices for establishing electrical connections between different modules. A known electrical connector for connecting to an FPC board aims at providing an FPC connector having a compact size and yet being capable to ensure reliable electrical connection with the FPC. Such a connector can be made small and thin in order to meet miniaturization requirements for use in compact electronics devices. The FPC can be securely fixed to the connector to establish and maintain electrical connection. The connector has a housing and contact elements disposed in the housing. The housing has a cavity between its top and bottom side. Each contact element has an upper contact arm disposed at the top side and a lower contact arm disposed at the bottom side. The cavity is to receive the FPC board therein to establish electrical connection with the upper and lower contact arms. A pair of locking members is attached to the housing.

An example for an FPC board connector is a card edge type connector, which has the form of a printed circuit board (PCB) comprising traces leading to the edge of the board. This type of connector is fairly robust and durable and can be built at low costs. A known card edge type connector comprises an FPC board with a card terminal and a female connector with a housing. The FPC has a portion forming at least a connector part in belt-shape and a wiring pattern of copper foil or the like is formed on an insulating film of PET or the like, and a cover layer of resin covers on top of it. The tip part of this FPC is folded back with the insulating film inside, and a plurality of openings are formed on the base end side adjoining the tip part of the cover layer. This plurality of openings functions as connector parts. The card terminal of the FPC can be inserted in and electrically connects to a respective female connector and the connection is fixed by a 180° flap and squeeze around a plastic wall.

However, presently known FPC board connectors do not provide a simulation of a 1.6 mm PCB thickness to allow standardized card edge connection or a free coupling flat flex cable (FFC) crimp MQS terminal where the size of 0,64 mm² and the pitch of 2,54 mm can be downsized and narrowed on demand. The known connectors also do not comprise housing designs that provide polarization and coding features to secure a mating only with a specified counterpart, which would be necessary for providing a standardized interface between an FPC board and a common cable harness. Therefore, there is still a need for an FPC board connector which provides an interface to household appliance industry standardized harnesses.

This object is solved by the subject matter of the independent claims. Advantageous embodiments of the present invention are the subject matter of the dependent claims.

The present invention relates to a connector system comprising a male connector with a first electrically insulated connector housing, a printed electronic circuitry with a terminal, and a female connector with a second electrically insulated connector housing. The printed electronic circuitry is in-molded with a supporting unit and is attached to the first electrically insulated connector housing of the male connector. The female connector is adapted to mate with the male connector and to be connected to a cable harness. Besides the support and fixation of the flexible circuitry, the housing also provides locking, coding and polarization features to mate a defined female connector which is part of an overall appliance harness system.

Advantageously, the printed electronic circuitry comprises an FPC, or a ceramic flexible circuit.

Moreover, the male connector may comprise a portion that is formed as a board with an edge and with traces leading to the edge, the traces being adapted to be plugged into the matching female connector to form a card edge connection. Preferably, the portion that is formed as a board has a thickness of 1.6 mm.

The advantage of the present invention is to provide a simulation of a 1.6 mm PCB thickness to allow standardized card edge connection or a free coupling FFC MQS 0.64 mm² pin connection including a fixation of the FPC board by the housing. Another advantage is that the housing design provides polarization and coding features to secure a mating only with a specified counterpart, which is necessary for providing a standardized interface between an FPC board and a common cable harness. Hence, the present invention provides an interface to household appliance industry standardized harnesses.

Advantageously, the first electrically insulated connector housing of the male connector comprises a movable latch which interacts with the supporting unit for locking the first electrically insulated connector housing of the male connector at the supporting unit.

In another example, the first electrically insulated connector housing of the male connector is fabricated by over-molding the terminal.

The terminal of the printed electronic circuitry may be attached to the first electrically insulated connector housing of the male connector by soldering the contacts of the terminal to the contacts of the first electrically insulated connector housing of the male connector.

In another example, the terminal of the printed electronic circuitry is attached to the first electrically insulated connector housing of the male connector by crimping the contacts of the terminal and by inserting the crimps in the first electrically insulated connector housing of the male connector.

The present invention also relates to a multi-layer interface comprising a connector system according to any of the embodiments described above. The multi-layer interface comprises at least one functional layer comprising the printed electronic circuit with a terminal, and at least one electrically insulating layer, which is different from the at least one functional layer and which comprises the electrically insulated connector housing of the male connector. The multi-layer interface may additionally comprise a decorative layer comprising film or natural materials, decorative links, and/or conductive and/or dielectric inks. Conductive inks can comprise for example silver ink and/or carbon.

Advantageously, the at least one functional layer comprises a polymer component in which the printed electronic circuit is embedded and/or a flexible printed circuit or any kind of suitable film or foil having a printed conductive circuitry. The at least one electrically insulating layer may comprise a plastic resin.

According to another example, the multi-layer interface is a human machine interface.

The present invention also relates to the fabrication of a multi-layer interface according to any of the embodiments described above. The fabrication comprises the steps of molding the electrically insulating layer onto the functional layer, and attaching the terminal of the printed electronic circuitry to the electrically insulated connector housing of the male connector of the electrically insulating layer. The fabrication may additionally comprise the step of molding at least one additional and/or decorative layer onto the electrically insulating layer. The injection molding process can be for example a one-shot or a two-shot molding process.The accompanying drawings are incorporated into the specification and form a part of the specification to illustrate several embodiments of the present invention. These drawings, together with the description serve to explain the principles of the invention. The drawings are merely for the purpose of illustrating the preferred and alternative examples of how the invention can be made and used, and are not to be construed as limiting the invention to only the illustrated and described embodiments. Furthermore, several aspects of the embodiments may form-individually or in different combinations-solutions according to the present invention. The following described embodiments thus can be considered either alone or in an arbitrary combination thereof. Further features and advantages will become apparent from the following more particular description of the various embodiments of the invention, as illustrated in the accompanying drawings, in which like references refer to like elements, and wherein:
- **FIG. 1A to 1E**: show the different stages of the assembly of a connector system comprising a male connector, comprising a printed electronic circuitry with a terminal, which is inserted in the connector housing, and a female connector mating with the male connector;
- **FIG. 2A to**: **2D** show the different stages of the assembly of a connector system comprising a printed electronic circuitry with a terminal, which is over-molded with a first electrically insulated connector housing of a male connector, and a female connector mating with the male connector;
- **FIG. 3A to 3D**: show the different stages of the assembly of a connector system comprising a printed electronic circuitry with a terminal, which is soldered to the soldering contacts of a first electrically insulated connector housing of a male connector, and a female connector mating with the male connector;
- **FIG. 4A to 4E**: show the different stages of the assembly of a connector system comprising a printed electronic circuitry with a terminal, with crimp contacts attached to the terminal and inserted in a female connector, and a male connector mating with the female connector;
- **FIG. 5A**: is an exploded view of a multi-layer interface comprising a functional layer with a terminal, an electrically insulating layer with a connector housing, and a decorative layer;
- **FIG. 5B**: is a perspective view of the multi-layer interface, wherein the layers are molded together and the terminal is inserted and in contact with the connector housing;
- **FIG. 6A to 6E**: show the different stages of the assembly of a multi-layer interface with a connector system comprising a terminal, which is inserted in a connector housing of a male connector and a female connector mating with the male connector to form a connector system;
- **FIG. 7A to 7D**: show the different stages of the assembly of a multi-layer interface with a connector system comprising a printed electronic circuitry with a terminal, which is over-molded with a first electrically insulated connector housing of a male connector, and a female connector mating with the male connector;
- **FIG. 8A to 8E**: show the different stages of the assembly of a multi-layer interface with a connector system comprising crimps being inserted in the connector housing of a male connector, and a female connector mating with the male connector;
- **FIG. 9A to 9E**: show the different stages of the assembly of a multi-layer interface with a connector system comprising crimps being inserted in the connector housing of a female connector, and a male connector mating with the female connector.

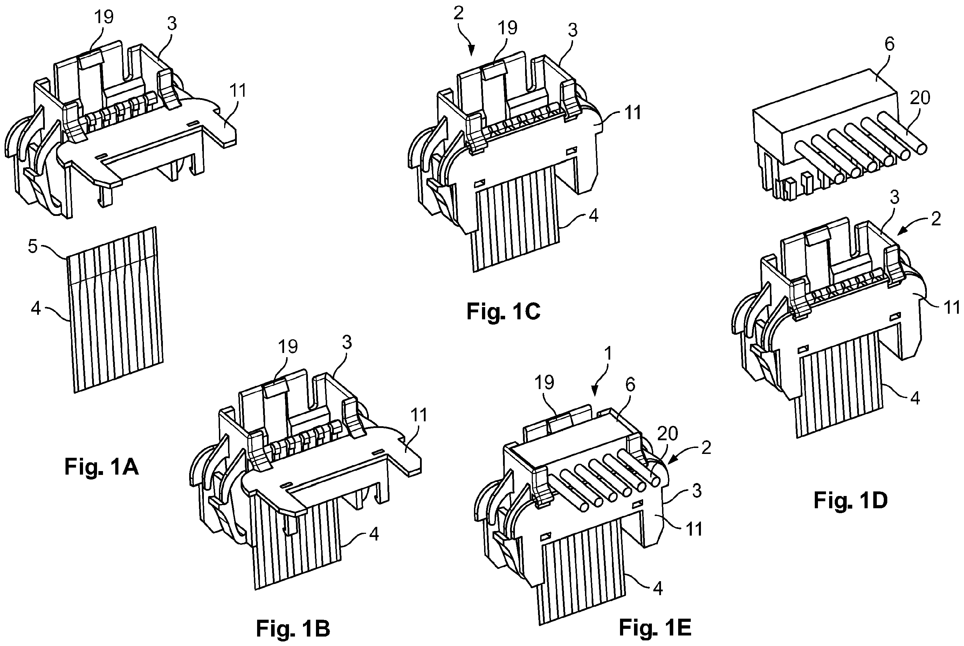

The present invention will now be explained in more detail with reference to the Figures and firstly referring to Figure 1A to 1E. Figure 1A shows a perspective drawing of a printed electronic circuitry 4 with a terminal 5 and a first electrically insulated connector housing 3. In Figure 1B, the terminal 5 of the printed electronic circuitry 4 is inserted in the first electrically insulated connector housing 3. The connector housing 3 can be mechanically fixed to the substrate of the terminal 5 of the printed electronic circuitry 4 by closing a latch 11, as shown in Figure 1C. When the terminal 5 is inserted in the connector housing 3, a card edge board comprising traces leading to the edge of the board is formed. These traces are either formed by the contacts of the terminal 5 of the printed electronic circuitry 4 or are in electrical contact to the contacts of the terminal 5 of the printed electronic circuitry 4. Hence, the terminal 5 and the connector housing 3 make up a male card edge connector 2, which can be used to connect the printed electronic circuitry 4. As shown in Figures 1D and 1E, the male connector 2 can mate with a corresponding female connector 6 to form a connector system 1. A catch mechanism 19 makes sure that the connection is not separated unintendedly. The connector system 1 can be used to establish an electrical connection of the printed electronic circuitry 4 to an external module via the electrical leads 20.

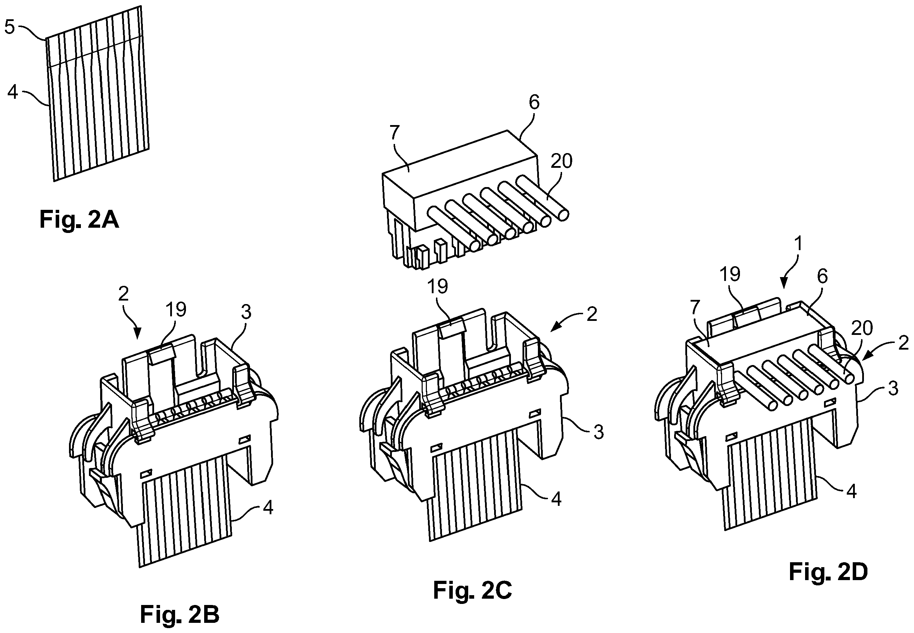

Figures 2A to 2D show another example, wherein a terminal 5 of a printed electronic circuitry 4 is connected to a connector housing 3 of a male connector 2. In contrast to the arrangement shown in Figures 1A to 1E, the terminal 5 is not mechanically fixed to the connector housing 3 by means of a latch 11, but the terminal 5 is over-molded with the connector housing 3, as shown in Figure 2B. Again, the terminal 5 and the connector housing 3 make up a male card edge connector 2, which can be used to connect the printed electronic circuitry 4. As shown in Figures 2D and 2E, the male connector 2 can mate with a corresponding female connector 6 to form a connector system 1. The connector system 1 can be used to establish an electrical connection of the printed electronic circuitry 4 to an external module.

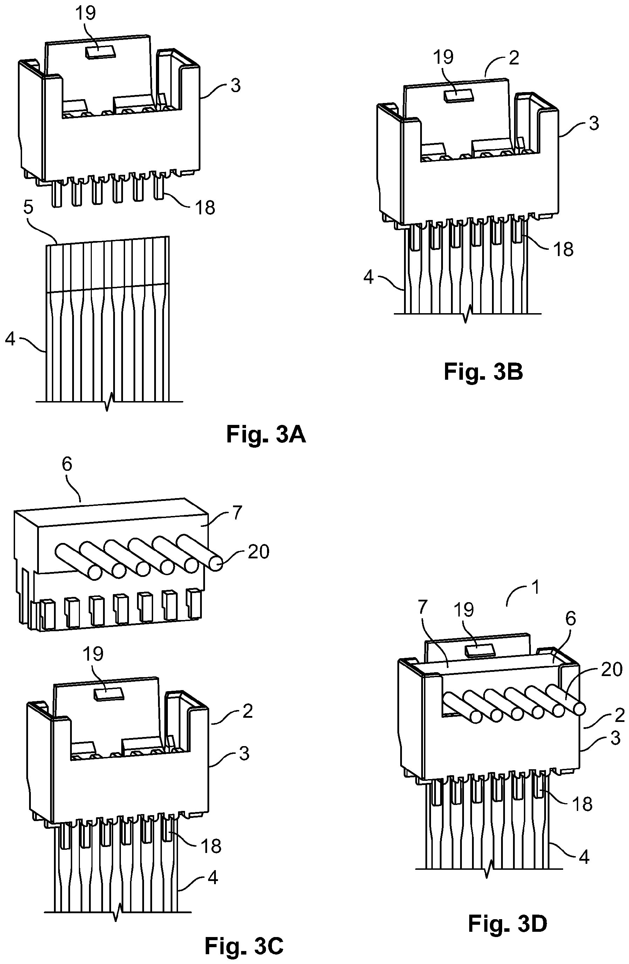

Figures 3A to 3D show another example of a connector system 1, wherein a terminal 5 of a printed electronic circuitry 4 is connected to a connector housing 3 of a male connector 2. As shown in Figure 3A, the connector housing 3 is equipped with soldering contacts 18. These soldering contacts 18 are soldered to the contacts of the terminal 5 of the printed electronic circuitry 4, as shown in Figure 3B. Again, the terminal 5 and the connector housing 3 make up a male card edge connector 2, which can be used to connect the printed electronic circuitry 4. As shown in Figures 3D and 3E, the male connector 2 can mate with a corresponding female connector 6 to form a connector system 1. The connector system 1 can be used to establish an electrical connection of the printed electronic circuitry 4 to an external module.

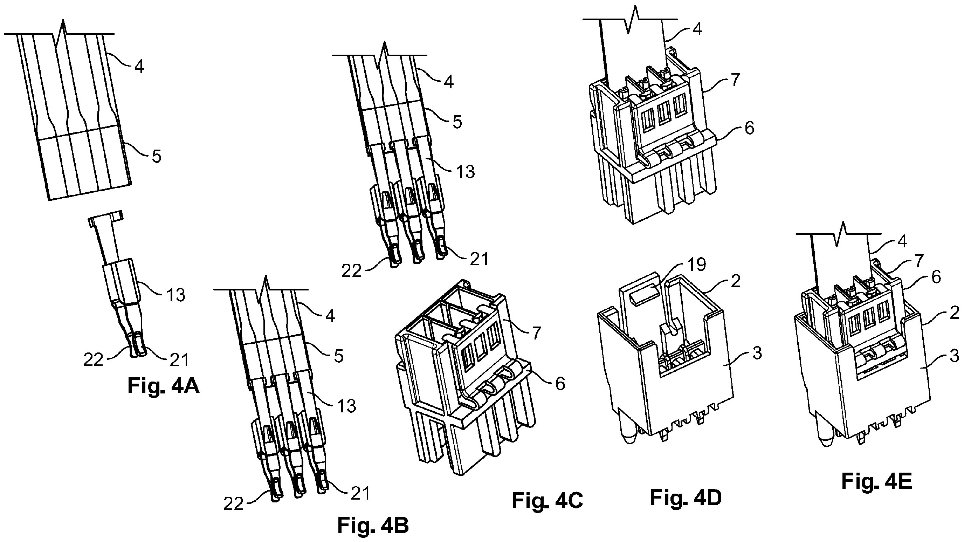

Figures 4A to 4D show another example of a connector system 1, wherein a terminal 5 of a printed electronic circuitry 4 is connected to a connector housing 7 of a female connector 6. As shown in Figures 4A and 4B, crimp contacts 13 are crimped to the terminal 5 of the printed electronic circuitry 4. The crimp contacts 13 establish an electrical connection between the contacts of the terminal 5 and the tips 21 of the crimp contacts 13. The parts of the crimp contacts 13, which overhang the terminal 5, are inserted in the connector housing 7 of a female connector 6. Figures 4A to 4C show that the tips 21 of the crimp contacts 13 are shaped as clamps 22 with two separate arms. When attached to the connector housing 7 of the female connecter 6, the clamps 22 can receive a male card edge connector 2 and establish an electrical connection thereto. This is shown in Figures 4D and 4E.

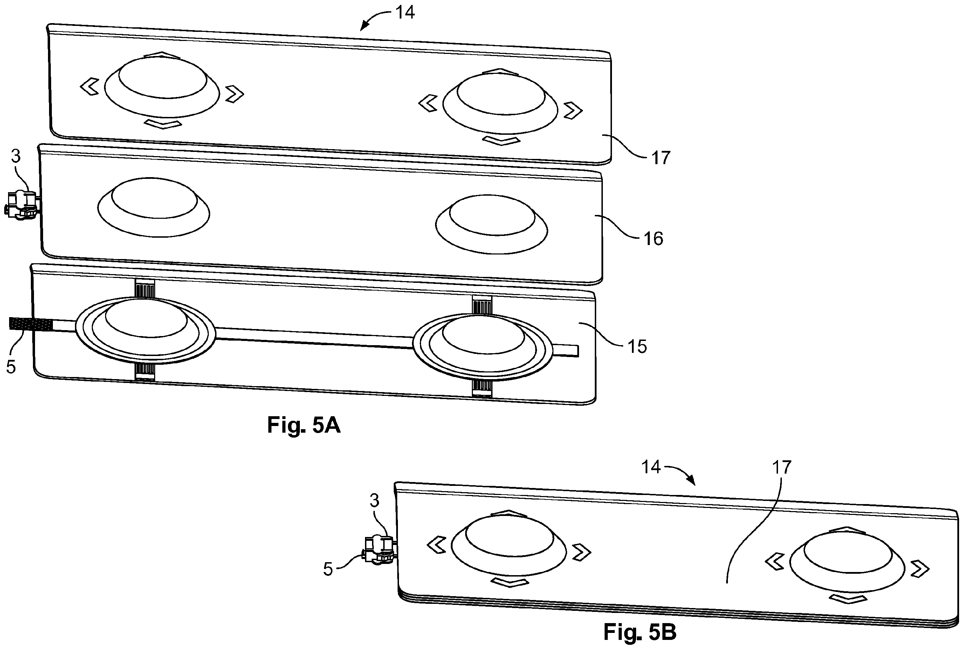

Figures 5A and 5B show an application of the connector system 1 according any of the above described embodiments. Figure 5A is an exploded view of a multi-layer interface 14 comprising a functional layer 15, an electrically insulating layer 16, and a decorative layer 17. The functional layer 15 comprises a printed electronic circuitry 4 with a film and conductive and/or dielectric inks. The printed electronic circuitry 4 also comprises a terminal 5 which protrudes from the functional layer 15. The electrically insulating layer 16 is preferably made of a plastic resin. The electrically insulating layer 16 comprises an electrically insulated connector housing 3, which protrudes from the electrically insulating layer 16 at the place that corresponds to the place on the functional layer 15 where the terminal 5 protrudes from the functional layer 15. The decorative layer 17 is molded on top of the functional layer 15 and the electrically insulating layer 16. The decorative layer 17 includes film or natural materials, as well as decorative inks and conductive and/or dielectric inks. The decorative layer 17 can for example provide information on the functions of the interface, such as labels of knobs.

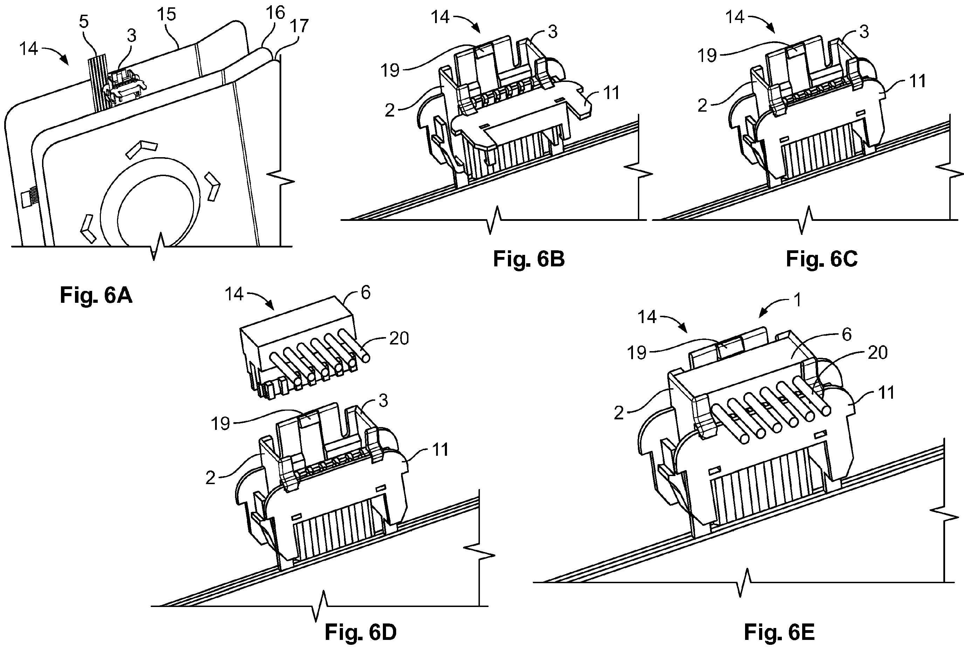

Figure 5B shows the multi-layer interface 14 in a state where the functional layer 15, the electrically insulating layer 16, and the decorative layer 17 are molded on top of each other. In this state, the terminal 5 of the printed electronic circuitry 4 is attached to the electrically insulated connector housing 3 in order to form a connector for connecting the multi-layer interface 14 with an external module. Thereby, the multi-layer interface 14 can be connected for example to a cable harness, where each cable of the harness is connected to a certain module. This would allow for controlling different modules via the multi-layer interface 14.Figure 6A is an exploded view of a multi-layer interface 14 comprising a functional layer 15 with a terminal 5, an electrically insulating layer 16 with a connector housing 3, and a decorative layer 17. In Figure 6B, the terminal 5 of the printed electronic circuitry 4 is inserted in the first electrically insulated connector housing 3. The connector housing 3 can be mechanically fixed to the substrate of the terminal 5 of the printed electronic circuitry 4 by closing a latch 11, as shown in Figure 6C. When the terminal 5 is inserted in the connector housing 3, a card edge board comprising traces leading to the edge of the board is formed. These traces are either formed by the contacts of the terminal 5 of the printed electronic circuitry 4 or are in electrical contact to the contacts of the terminal 5 of the printed electronic circuitry 4. Hence, the terminal 5 and the connector housing 3 make up a male card edge connector 2, which can be used to connect the printed electronic circuitry 4. As shown in Figures 6D and 6E, the male connector 2 can mate with a corresponding female connector 6 to form a connector system 1. The connector system 1 can be used to establish an electrical connection of the printed electronic circuitry 4 to an external module.

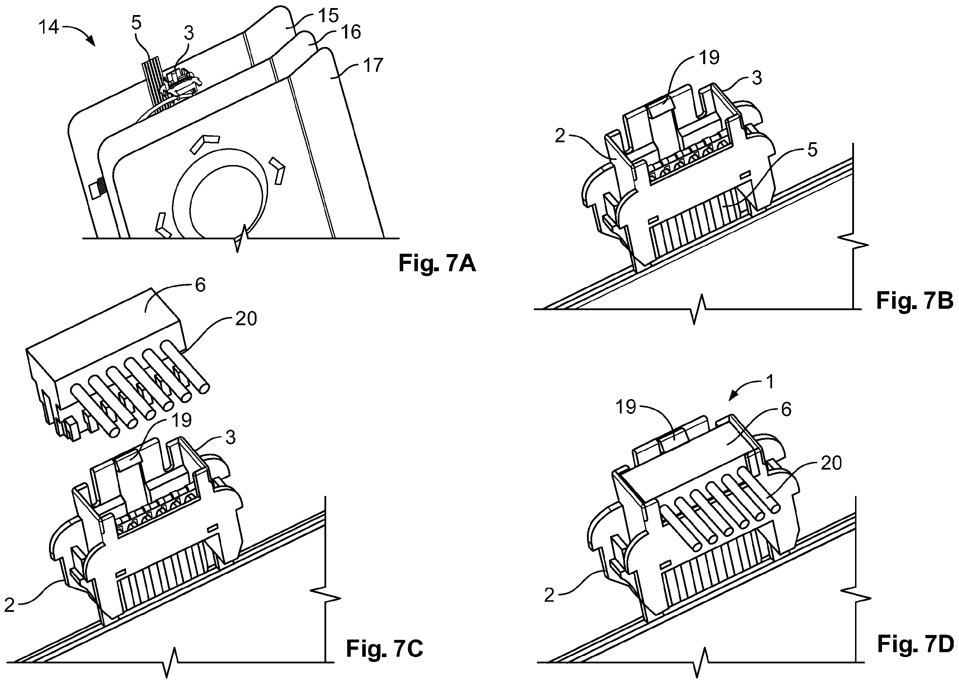

Figure 7A is an exploded view of a multi-layer interface 14 comprising a functional layer 15 with a terminal 5, an electrically insulating layer 16 with a connector housing 3, and a decorative layer 17. In Figure 6B, the terminal 5 of the printed electronic circuitry 4 is over-molded with the first electrically insulated connector housing 3. Again, the terminal 5 and the connector housing 3 make up a male card edge connector 2, which can be used to connect the printed electronic circuitry 4. As shown in Figures 7C and 7D, the male connector 2 can mate with a corresponding female connector 6 to form a connector system 1. The connector system 1 can be used to establish an electrical connection of the printed electronic circuitry 4 to an external module.

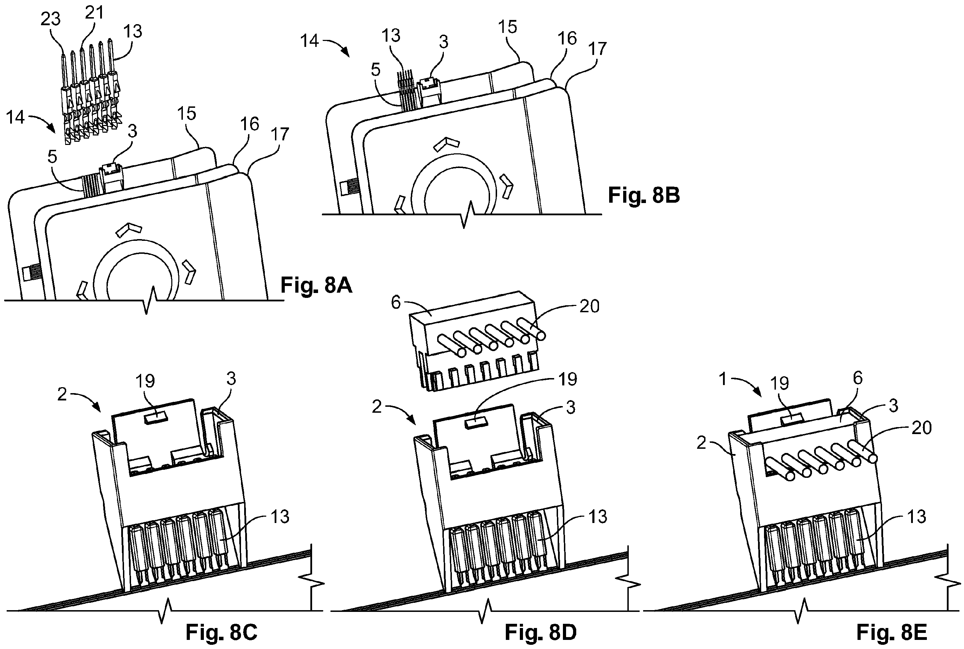

Figure 8A is an exploded view of a multi-layer interface 14 comprising a functional layer 15 with a terminal 5, an electrically insulating layer 16 with a connector housing 3, and a decorative layer 17, and crimps 13.

As shown in Figures 8A and 8B, crimp contacts 13 are crimped to the terminal 5 of the printed electronic circuitry 4. The crimp contacts 13 establish an electrical connection between the contacts of the terminal 5 and the tips 21 of the crimp contacts 13. The parts of the crimp contacts 13, which overhang the terminal 5, are inserted in the connector housing 3 of a male connector 2. Figure 8A shows that the tips 21 of the crimp contacts 13 are shaped as studs 23. When attached to the connector housing 3 of the male connecter 2, the studs 23 can be inserted into a female card edge connector 6 and establish an electrical connection thereto. This is shown in Figures 8D and 8E.

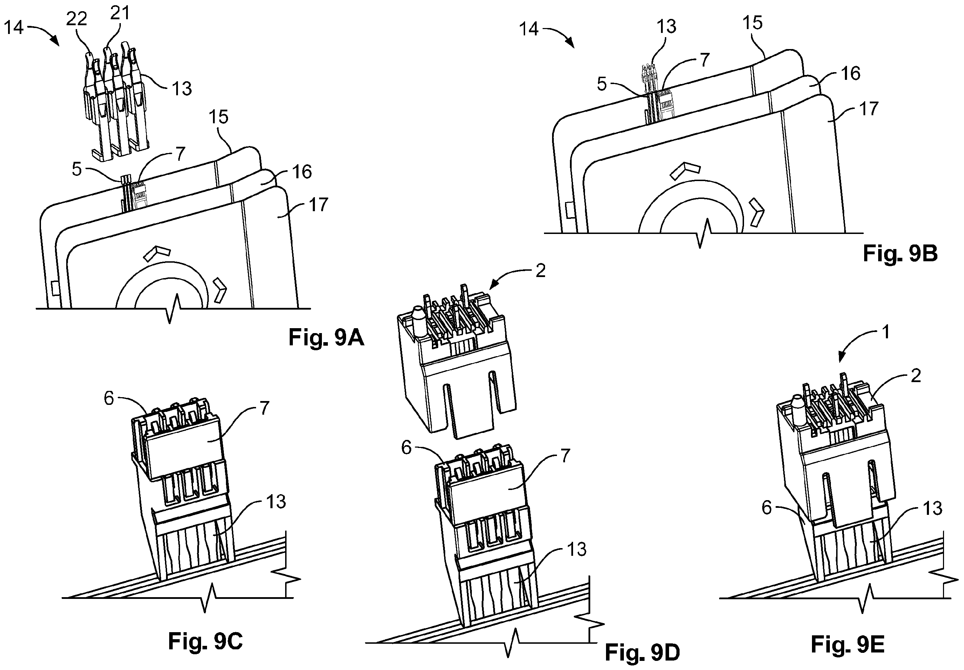

Figure 9A is an exploded view of a multi-layer interface 14 comprising a functional layer 15 with a terminal 5, an electrically insulating layer 16 with a connector housing 7 of a female connector 6, and a decorative layer 17, and crimps 13. As shown in Figures 9A and 9B, crimp contacts 13 are crimped to the terminal 5 of the printed electronic circuitry 4. The crimp contacts 13 establish an electrical connection between the contacts of the terminal 5 and the tips 21 of the crimp contacts 13. The parts of the crimp contacts 13, which overhang the terminal 5, are inserted in the connector housing 7 of a female connector 6. Figure 9A shows that the tips 21 of the crimp contacts 13 are shaped as clamps 22 with two separate arms. When attached to the connector housing 7 of the female connecter 6, the clamps 22 can receive a male card edge connector 2 and establish an electrical connection thereto. This is shown in Figures 9D and 9E.

**REFERENCE NUMERALS**

| **Reference Numeral** | **Description** |
|---|---|
| 1 | connector system |
| 2 | male connector |
| 3 | first electrically insulated connector housing |
| 4 | printed electronic circuitry |
| 5 | terminal of the printed electronic circuitry |
| 6 | female connector |
| 7 | second electrically insulated connector housing |
| 8 | portion of the male connector formed as a board |
| 9 | edge |
| 10 | traces |
| 11 | latch |
| 12 | supporting unit |
| 13 | crimp |
| 14 | multi-layer interface |
| 15 | functional layer |
| 16 | electrically insulating layer |
| 17 | decorative layer |
| 18 | soldering contacts |
| 19 | catch mechanism |
| 20 | electrical leads |
| 21 | tip of the crimp |
| 22 | clamp |
| 23 | stud |

## Claims

1. A connector system (1) comprising
a male connector (2) with a first electrically insulated connector housing (3);
a printed electronic circuitry (4) with a terminal (5), wherein
the printed electronic circuitry (4) is in-molded with a supporting unit (12),
the terminal (5) of the printed electronic circuitry (4) is attached to the first electrically insulated connector housing (3) of the male connector (2); and
a female connector (6) with a second electrically insulated connector housing (7), wherein
the female connector (6) is adapted to mate with the male connector (2),
the female connector (6) is adapted to be connected to a cable harness.

2. The connector system (1) according to claim 1, wherein
the printed electronic circuitry (4) comprises a flexible printed circuit, FPC, or a ceramic flexible circuit.

3. The connector system (1) according to any of the preceding claims, wherein
the male connector (2) comprises a portion that is formed as a board (8) with an edge (9) and with traces (10) leading to the edge (9), the traces (10) being adapted to be plugged into the matching female connector (6) to form a card edge (9) connection.

4. The connector system (1) according to claim 3, wherein
the portion that is formed as a board (8) has a thickness of 1.6 mm.

5. The connector system (1) according to any of the preceding claims, wherein
the first electrically insulated connector housing (3) of the male connector (2) comprises a movable latch (11) which interacts with the supporting unit (12) for locking the first electrically insulated connector housing (3) of the male connector (2) at the supporting unit (12).

6. The connector system (1) according to any of the preceding claims, wherein
the first electrically insulated connector housing (3) of the male connector (2) is fabricated by over-molding the terminal (5).

7. The connector system (1) according to any of the preceding claims, wherein
the terminal (5) of the printed electronic circuitry (4) is attached to the first electrically insulated connector housing (3) of the male connector (2) by soldering the contacts of the terminal (5) to the contacts (18) of the first electrically insulated connector housing (3) of the male connector (2).

8. The connector system (1) according to any of the preceding claims, wherein
the terminal (5) of the printed electronic circuitry (4) is attached to the first electrically insulated connector housing (3) of the male connector (2) by
crimping the contacts of the terminal (5); and
inserting the crimps (13) in the first electrically insulated connector housing (3) of the male connector (2).

9. A multi-layer interface (14) comprising a connector system (1) according to any of the preceding claims, the multi-layer interface (14) comprising
at least one functional layer (15) comprising the printed electronic circuit with a terminal (5), and
at least one electrically insulating layer (16),
which is different from the at least one functional layer (15), and
which comprises the electrically insulated connector housing of the male connector (2).

10. The multi-layer interface (14) according to claim 9, wherein
the at least one functional layer (15) comprises a polymer component in which the printed electronic circuit is embedded.

11. The multi-layer interface (14) according to any of claims 9 to 10, wherein
the at least one functional layer (15) comprises a flexible printed circuit or any kind of suitable film or foil having a printed conductive circuitry.

12. The multi-layer interface (14) according to any of claims 9 to 11, wherein
the at least one electrically insulating layer (16) comprises a plastic resin.

13. The multi-layer interface (14) according to any of claims 9 to 12, wherein
the multi-layer interface (14) additionally comprises a decorative layer (17) comprising film or natural materials, decorative links, and/or conductive and/or dielectric inks.

14. The multi-layer interface (14) according to any of claims 9 to 13, wherein
the multi-layer interface (14) is a human machine interface.

15. Fabrication of a multi-layer interface (14) according to claims 9 to 14, the fabrication comprising steps of
molding the electrically insulating layer (16) onto the functional layer (15);
attaching the terminal (5) of the printed electronic circuitry (4) to the electrically insulated connector housing of the male connector (2) of the electrically insulating layer (16).

16. Fabrication of a multi-layer interface (14) according to claim 15, the fabrication additionally comprising the step of
molding at least one additional and/or decorative layer (17) onto the electrically insulating layer (16).
